# EUROPÄISCHE PATENTSCHRIFT

(11) **EP 0 363 658 B1**
(45) Veröffentlichungstag und Bekanntmachung des Hinweises auf die Patenterteilung: **04.08.1993**
(21) Anmeldenummer: 89116776.9
(22) Anmeldetag: 11.09.1989
(51) Int. Cl.: G01R 33/022

(54) **Supraleitendes Gradiometerschleifen-system einer mehrkanaligen Messeinrichtung**
Superconducting gradiometer loop system for a multichannel measuring device
Système de gradiomètre à boucles supraconductives pour un dispositif de mesure à canaux multiples

(30) Priorität: 22.09.1988 DE 3832129
(43) Veröffentlichungstag der Anmeldung: 18.04.1990
(73) Patentinhaber: SIEMENS AKTIENGESELLSCHAFT, 80333 München (DE)
(72) Erfinder: Seifert, Heinrich, Dr., D-8526 Bubenreuth (DE)

(56) Entgegenhaltungen:
- EP-A- 0 130 490

## Beschreibung

Die Erfindung bezieht sich auf eine mehrkanalige Meßeinrichtung mit supraleitenden Gradiometerschleifen gemäß dem gattungsbildenden Oberbegriff des Anspruchs 1. Eine derartige Meßeinrichtung ist aus der EP-B-0 111 827 bekannt.

Zur Messung sehr schwacher Magnetfelder ist eine Verwendung von supraleitenden Quanten-Interferometern, sogenannten "SQUIDs" (Abkürzung von: Superconducting QUantum Interference Devices), allgemein bekannt (vgl. z.B. "J. Phys.E.: Sci.Instr.", Vol. 13, 1980, Seiten 801 bis 813 oder "IEEE Trans.Electron Dev.", Vol. ED-27, No. 10, Oktober 1980, Seiten 1896 bis 1908). Als ein bevorzugtes Anwendungsgebiet für diese Interferometer wird auf dem Gebiet der medizinischen Diagnostik die Magnetokardiographie oder Magnetoenzephalographie angesehen. Die hierbei hervorgerufenen Magnetfelder von magnetischen Herzbzw. Gehirnwellen haben nämlich Feldstärken in der Größenordnung von nur etwa 50 pT bzw. 0,1 pT (vgl. z.B. "Biomagnetism - Proceedings Third International Workshop on Biomagnetism, Berlin 1980", Berlin/New York 1981, Seiten 3 bis 31). Diese sehr schwachen Felder müssen zudem noch bei Anwesenheit von vergleichsweise großen Störfeldern zu detektieren sein. Zur Messung derartiger biomagnetischer Felder in der genannten Größenordnung sind Meßeinrichtungen bekannt, die ein- oder insbesondere mehrkanalig ausgeführt sein können. Eine derartige Meßeinrichtung enthält im allgemeinen pro Kanal ein Gradiometer aus supraleitenden Gradiometerschleifen, ein SQUID sowie sich zwischen dem SQUID und den Gradiometerschleifen erstreckende supraleitende Verbindungsleiter. Dabei wird jeweils die der zu detektierenden magnetischen Feldquelle zugewandte Schleife auch als Detektionsschleife bezeichnet, während die davon räumlich weiter entferntere Schleife als eine Kompensationsschleife angesehen werden kann. Mit einem solchen Schleifensystem ist vorteilhaft direkt der magnetische Fluß der Feldquelle zu messen, wobei eine sehr hohe Empfindlichkeit und eine gute Diskriminierung von äußeren Störfeldern zu erreichen ist.

Die Gradiometerschleifen sowie die zugehörenden Verbindungsleiter können beispielsweise aus supraleitendem Draht aufgebaut sein, wobei sich die Verbindungsleitungen zusätzlich in einer supraleitenden Abschirmung befinden können. Im allgemeinen lassen sich aus Draht aber nur runde Schleifen mit der notwendigen Genauigkeit herstellen. Außerdem können die Verbindungsleitungen nicht induktionsfrei und feldunempfindlich kontaktiert werden. Ferner müssen bei vielkanaligen Meßeinrichtungen sehr viele Einzeleinheiten gehandhabt werden. Statt diskrete supraleitende Drähte zu verwenden, können die Gradiometerschleifen und die zugehörigen Verbindungsleiter auch als Dünnfilmleiter auf Trägerfolien abgeschieden sein. Die beschichteten Trägerfolien werden dann auf einem Trägerkörper mit ausgeprägt dreidimensionaler Gestalt aufgebracht (vgl. z.B. EP-A-0 185 186). Bei dieser Ausführungsform läßt sich jedoch nicht vermeiden, daß die jeweils Paare parallelgeführter Leiter bildenden Verbindungsleiter aufgrund ihres nur endlichen Leiterabstandes ebenfalls feldempfindlich sind.

Bei der aus der eingangs genannten EP-B bekannten vielkanaligen Meßeinrichtung sind die Detektionsschleifen und die Kompensationsschleifen jeweils zu einem planaren Schleifenfeld, einem sogenannten Array, zusammengefaßt. Dabei sind die beiden Schleifenarrays auf zwei gegenüberliegenden Flachseiten eines dreidimensionalen Trägerkörpers angeordnet. Bei dieser Meßeinrichtung kann jedoch die für jedes Array zur Verfügung stehende Array-Fläche nicht vollständig für die Gradiometerschleifen genutzt werden. Benachbarte Schleifen müssen nämlich hinreichend beabstandet sein, um die erforderlichen Verbindungsleiter hindurchführen zu können. Dabei ist nicht zu vermeiden, daß die dort verlaufenden Verbindungsleiter feldempfindlich sind.

Aufgabe der vorliegenden Erfindung ist es deshalb, die Meßeinrichtung gemäß dem Oberbegriff des Anspruchs 1 dahingehend auszugestalten, daß eine optimale Nutzung der Array-Flächen ermöglicht wird. Dabei soll außerdem eine Feldempfindlichkeit der Verbindungsleiter zumindest weitgehend unterdrückt werden.

Diese Aufgabe wird erfindungsgemäß mit den im kennzeichnenden Teil des Anspruchs 1 angegebenen Maßnahmen gelöst.

Bei der erfindungsgemäßen Ausgestaltung der Meßeinrichtung sind also die einzelnen Gradiometerschleifen sowie die zugehörigen Verbindungsleiter in an sich bekannter Weise auf Trägerfolien ausgebildet (vgl. die EP-A-0 185 186). Hierzu werden vorteilhaft die beiden Seiten der Trägerfolien ausgenutzt. Es läßt sich so erreichen, daß die Gradiometerschleifen eines Arrays untereinander so dicht gepackt werden können, daß zwischen ihnen praktisch nur minimale Zwischenräume zur gegenseitigen elektrischen Isolation verbleiben. Der elektrische Anschluß der einzelnen Schleifen im Bereich eines Arrays erfolgt dann über Verbindungsleiter, die der Kontur von Leiterbahnen folgen, welche auf der jeweils gegenüberliegenden Flachseite liegende Gradiometerschleifen bilden. Auf diese Weise dienen die Gradiometerschleifen gleichzeitig auch als magnetische Abschirmung für die Verbindungsleiter. Die Anordnung der einzelnen Gradiometerschleifen auf den beiden Seiten einer Trägerfolie wird folglich auch unter Berücksichtigung der für ihren elektrischen Anschluß erforderlichen Verbindungsleiter gewählt. Dabei kann vorteilhaft erreicht werden, daß Durchkontaktierungen im Bereich des von einem Array eingenommenen, als "Array-Fläche" oder "Array-Bereich" bezeichneten Teils einer Folie vermieden werden. Mit solchen Gradiometerschleifen-Arrays auf den Trägerfolien lassen sich dann ohne weiteres Gradiometer nullter, erster oder höherer Ordnung ausbilden, indem diese Trägerfolien auf einer durch die Ordnung des Gradiometers bestimmten Anzahl von Flachseiten mindestens eines Trägerkörpers aufgebracht und die aus den Arraybereichen herausgeführten Verbindungsleiter miteinander entsprechend zusammengeschaltet werden.

Vorteilhafte Ausgestaltungen der Meßeinrichtung nach der Erfindung gehen aus den Unteransprüchen hervor.

Zur weiteren Erläuterung der Erfindung wird nachfolgend auf die schematische Zeichnung Bezug genommen, in deren Figuren 1 und 2 die beiden mit einem Gradiometerschleifen-Array versehenen Flachseiten einer Trägerfolie einer erfindungsgemäßen Meßeinrichtung wiedergegeben sind. In Figur 3 ist der mechanische Aufbau eines Gradiometerschleifensystems mit solchen Gradiometerschleifen-Arrays angedeutet. Aus den Figuren 4 und 5 sind als Folienleiter ausgebildete Verbindungsleiter für die Gradiometerschleifen ersichtlich. Aus Figur 6 geht die elektrische Leitungsführung für diese Verbindungsleiter hervor. In den Figuren sind sich entsprechende Teile mit denselben Bezugszeichen versehen.

Als Ausführungsbeispiel sei nachfolgend eine Meßeinrichtung zur Magnetoenzephalographie oder -kardiographie zugrundegelegt, die ein 37-Kanal-Gradiometer erster Ordnung mit drei Magnetometerkanälen aufweist. Das Gradiometer sei aus zwei jeweils mit einer entsprechenden Anzahl von Gradiometerschleifen belegten Trägerfolien zusammengesetzt. Das so erhaltene Gradiometerschleifensystem soll über vier Trägerfolien mit den erforderlichen Verbindungsleitern an SQUIDs angeschlossen werden.

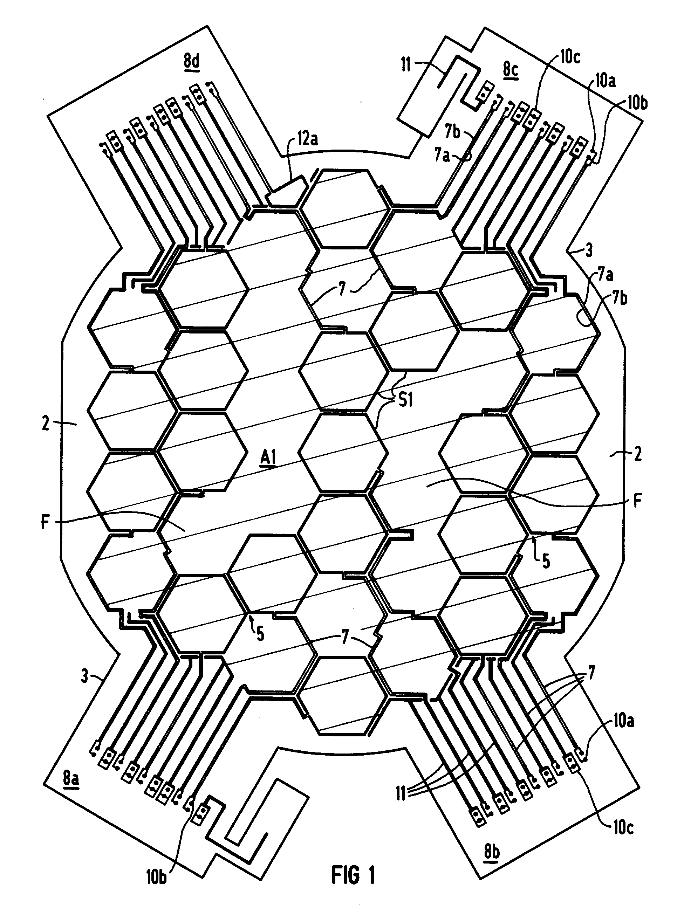

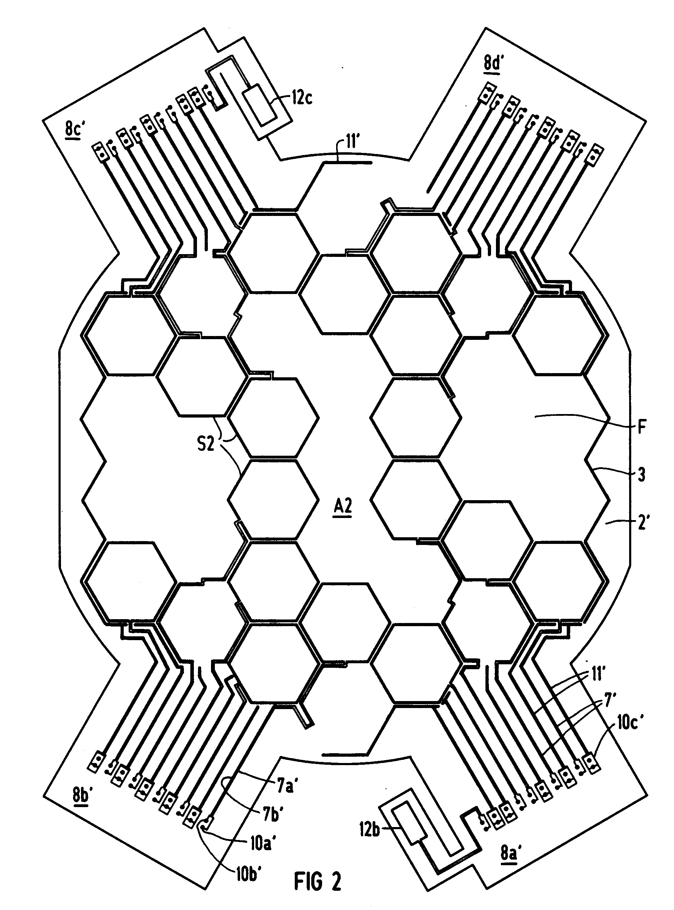

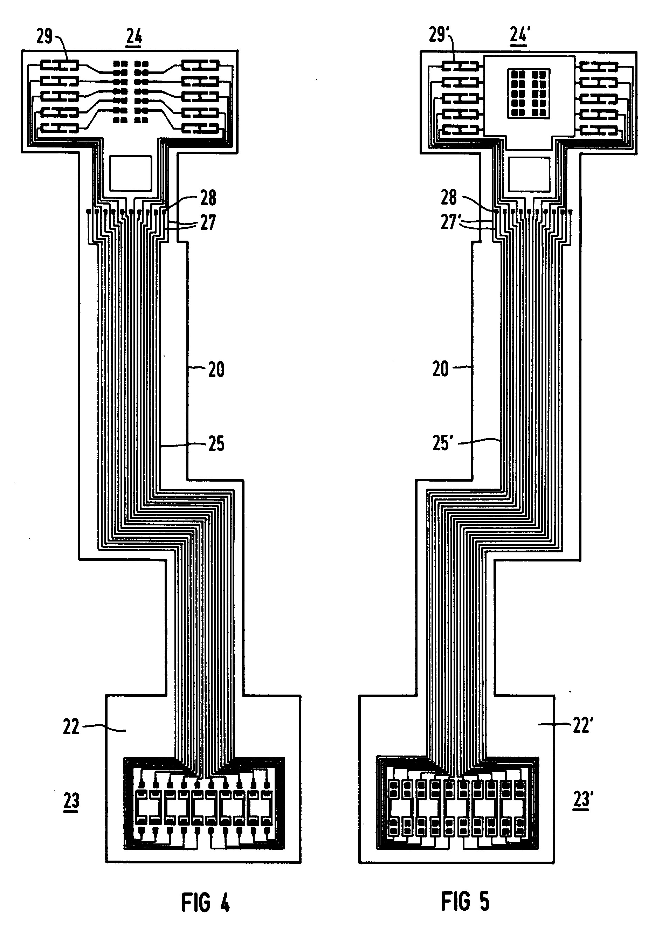

Aus der in Figur 1 ersichtlichen Aufsicht auf eine Flachseite 2 einer an sich bekannten flexiblen Trägerfolie 3 ist ein Teil Al eines Arrays von sechseckigen supraleitenden Gradiometerschleifen oder -spulen ersichtlich. Die restlichen Gradiometerschleifen dieses Arrays gehen aus einer entsprechenden Darstellung der Figur 2 hervor und bilden dort einen Arrayteil A2. Bei gleichzeitiger Betrachtung der beiden Array-Teile A1 und A2 nehmen deren supraleitende Gradiometerschleifen einen bestimmten Teil der Trägerfolie 3 ein. Diesem Teil ist eine Fläche F zuzuordnen, die nachfolgend als "Arrayfläche" F bezeichnet sei und in der Figur 1 durch eine Schraffur angedeutet ist. Diese Fläche wird durch 37 Gradiometerschleifen entsprechend der Zahl der vorgesehenen Kanäle der Meßeinrichtung festgelegt. Diese Gradiometerschleifen sind zu beiden Seiten der Trägerfolie 3 so angeordnet, daß sie einerseits sich nicht überlappen, andererseits aber eine möglichst dichte (geschlossene) Packung ermöglichen. Es sei angenommen, daß sich das in den Figuren 1 und 2 wiedergegebene, aus den Arrayteilen A1 und A2 zusammensetzende Array auf der einer zu detektierenden magnetischen Feldquelle zugewandten Seite eines Trägerkörpers mit ausgeprägt dreidimensionaler Gestalt befinden soll. Dann können seine Gradiometerschleifen als Detektionsschleifen angesehen werden. Eine weitere, mit einem entsprechenden Array von Gradiometerschleifen belegte Trägerfolie wird auf einer gegenüberliegenden, dazu parallelen Fläche des Trägerkörpers aufgebracht. Seine Gradiometerschleifen können deshalb auch als Kompensationsschleifen angesehen werden.

Gemäß Figur 1 sind lediglich 19 der 37 Detektionsschleifen des Arrayteiles A1 auf der Flachseite 2 ausgebildet und einheitlich mit S1 bezeichnet. Benachbarte Detektionsschleifen sind nur durch einen Isolierspalt 5 getrennt. Jede Detektionsschleife ist über supraleitende Verbindungsleiter an ein SQUID angeschlossen. Von diesen Verbindungsleitern sind auf der Flachseite 2 nur Teilstücke 7a und 7b abgeschieden. Die jeweils einer Gradiometerschleife S1 zuzuordnenden beiden Teilstücke sind dabei vorteilhaft als Doppelleitung 7 zur Hin- und Rückleitung des Stromes ausgebildet. Diese Doppelleitungen führen, ohne Überkreuzungen zu bilden, aus dem Bereich der Arrayfläche F zu 4 Reihen 8a bis 8d von Anschlußpunkten 10a, 10b. Im Bereich der Fläche F sind die Position der einzelnen Detektionsschleifen S1 sowie der Verlauf der Doppelleitungen 7 so gewählt, daß diese Doppelleitungen genau oberhalb der supraleitenden Leiterbahnen von Detektionsschleifen des Arrayteils A2 zu liegen kommen, welcher auf der gegenüberliegenden Flachseite der Trägerfolie ausgebildet ist. Auf diese Weise stellen die Leiterbahnen der Gradiometerschleifen für die von ihnen abgedeckten Teilstücke der Verbindungsleiter Abschirmungen gegen unerwünschte Magnetfeldeinflüsse dar.

Um auch außerhalb des Bereichs der Arrayfläche F eine entsprechende Abschirmung der Doppelleitungen mit gegenläufiger Stromflußrichtung zu erreichen, sind auf der jeweils gegenüberliegenden Flachseite zusätzliche Leiterbahnen vorgesehen, welche entsprechend den abzuschirmenden Teilen verlaufen. In Figur 1 sind derartige Abschirmleiter mit 11 bezeichnet. Sie sind breit genug, um die in der darunterliegenden Ebene liegenden Doppelleitungen abschirmend abzudecken. Die Abschirmleiter 11 werden an Kontaktpunkten 10c der Reihen 8a bis 8d angeschlossen.

Wie aus Figur 1 ferner ersichtlich, kann am Außenrand der Arrayfläche F in einem von 2 Detektionsschleifen gebildeten Zwickel noch eine Magnetometer-Schleife 12a zur Detektion des nicht-kompensierten Magnetfeldes vorgesehen werden.

Aus Figur 2 ist eine Aufsicht auf die gegenüberliegende (untere) Flachseite 2' der Trägerfolie 3 ersichtlich. Auf dieser Flachseite sind 18 Detektionsschleifen S2 eines Arrayteiles A2 so angeordnet, daß sie zusammen mit den 19 Detektionsschleifen S1 gemäß Figur 1 die Arrayfläche praktisch vollständig, d.h. ohne größere Isolierspalte 5 abdecken. Die Teilstücke 7a' und 7b' der supraleitenden Verbindungsleiter sind so gelegt, daß sie von Leiterbahnen der auf der gegenüberliegenden (oberen) Flachseite befindlichen Detektionsschleifen gegenüber dem zu detektierenden Magnetfeldern sowie magnetischen Störfeldern abgeschirmt sind. Hierzu sind die Teilstücke 7a' und 7b' ebenfalls auch als Doppelleitungen 7' ausgebildet. Aus der Figur sind ferner Reihen 8a' bis 8d' für Anschlußpunkte 10a' bis 10c' für die Leiterteilstücke 7a' und 7b' sowie für Abschirmleiter 11' ersichtlich. Außerdem liegen auf der Flachseite 2' noch zwei Magnetometer-Schleifen 12b und 12c.

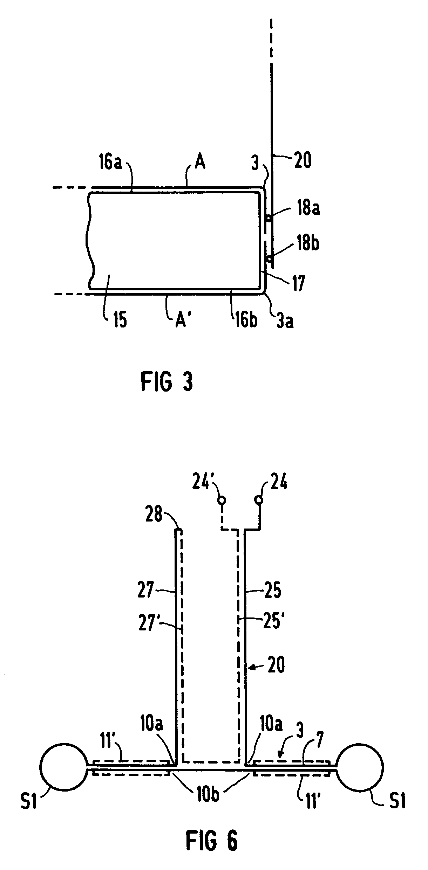

Ein für ein Gradiometer erster Ordnung erforderliches weiteres Array von Komponsationsschleifen kann vorteilhaft wie das in den Figuren 1 und 2 veranschaulichte Array A1 + A2 der Detektionsschleifen S1 + S2 ausgebildet sein. Der mechanische Aufbau eines entsprechenden Gradiometers bzw. Gradiometerschleifensystems aus zwei solchen Arrays ist in Figur 3 angedeutet. Aus dem Schnitt dieser Figur durch einen Teil des Gradiometers ist ein Trägerkörper 15 mit ausgeprägt dreidimensionaler Gestalt, beispielsweise mit Zylinderform, zu entnehmen. Auf seinen gegenüberliegenden flachen Stirnseiten 16a, 16b wird das Array A aus Detektionsschleifen bzw. das Array A' aus Kompensationsschleifen angeordnet. Beispielsweise werden die entsprechenden Trägerfolien 3 und 3a dieser Arrays dort aufgeklebt. Die über die jeweilige Arrayfläche hinausragenden Teile der Trägerfolien sind aus den parallelen Ebenen der Stirnseiten 16a, 16b in eine dazu senkrechte Seitenfläche 17 herumgebogen. Dort sind die weiteren Teile der supraleitenden Verbindungsleiter an ihre Reihen von Anschlußpunkten angelötet. Die beispielsweise an den Reihen 8b und 8b' ausgebildeten Lötverbindungen sind mit 18 bzw. 18a bezeichnet. Die zwischen diesen Lötverbindungen und Anschlüssen für zugeordnete SQUIDs vorzusehenden Teile der supraleitenden Verbindungsleiter werden vorteilhaft ebenfalls als bandförmige Zuleitungsfolien ausgebildet. Ein Ausführungsbeispiel einer solchen Zuleitungsfolie für die Detektionsschleifen S1, S2 des Arrays A geht aus den Figuren 4 und 5 hervor.

Aus Figur 4 ist eine Aufsicht auf die eine (obere) Flachseite 22 einer Zuleitungsfolie 20 ersichtlich. Auf dieser Folie sind zwischen Anschlußreihen 23 und 24 verlaufende Teile der supraleitenden Verbindungsleiter als eng benachbarte, untereinander parallele Leiterbahnen 25 abgeschieden. Eine Aufsicht auf die entsprechende untere Flachseite 22' der Folie 20 geht aus Figur 5 hervor. Dort sind die die Anschlußreihen 23 und 24 gemäß Figur 4 abdeckenden Anschlußreihen mit 23' bzw. 24' sowie die Leiterbahnen mit 25' bezeichnet. Auf der Zuleitungsfolie 20 sind dabei die einzelnen Leiterbahnen auch im Bereich der Anschlußreihen so verlegt, daß eine hinreichende Abschirmung erreicht wird. Hierfür sind auf den beiden Flachseiten 22 und 22' zusätzliche Leiterbahnen 27 bzw. 27' vorgesehen, die paarweise übereinanderliegen. Diese zusätzlichen Leiterbahnen sind am Rand des Bereichs der Anschlußreihen 24 und 24' an durch die Zuleitungsfolie 20 durchgehenden Kontaktstellen 28 miteinander kurzgeschlossen. Wie aus den Figuren 4 und 5 ferner hervorgeht, sind mit den Leiterbahnen 25 und 25' in der Nähe der Anschlußreihen 24 und 24' Transformatorschleifen 29 bzw. 29' für eine Feedback-Einkopplung ausgebildet.

Die elektrische Leitungsführung zum Anschluß der einzelnen Gradiometerschleifen an die zugehörigen SQUIDs über die supraleitenden Verbindungsleiter geht aus der Skizze der Figur 6 hervor. In dieser Figur sind die auf den oberen Flachseiten 22 und 2 verlaufenden Leiterteile mit durchgezogenen Linien veranschaulicht, während die jeweils in den gegenüberliegenden (unteren) Flachseiten 22' und 2' abgeschiedenen Teile mit gestrichelten Linien dargestellt sind. In der Figur sind ferner auch die beiden Abschirmleiter 11' angedeutet, welche die Doppelleitungen 7 der supraleitenden Verbindungsleiter zwischen einer Reihe von Anschlußpunkten 10a, 10b und einzelnen Detektionsschleifen S1 abdecken.

Für das in den Figuren angedeutete Gradiometer sind noch weitere Zuleitungsfolien erforderlich, die zwischen die Reihen der Anschlußpunkte der einzelnen Gradiometerschleifen und die zugeordneten SQUIDs zu schalten sind. Diese weiteren Zuleitungsfolien sind entsprechend der Darstellung nach den Figuren 4 bis 6 auszubilden und anzuschließen. Alle Zuleitungsfolien können insbesondere auf mindestens einer Trägerstruktur angeordnet werden, die z.B. mit dem Trägerkörper für die Gradiometerschleifenarrays starr verbunden wird (vgl. EP-B-0 111 827).

Das in den Figuren angedeutete Gradiometerschleifensystem in Folienausführung zeichnet sich insbesondere durch folgende Merkmale aus:
- Die zur Verfügung stehende Arrayfläche wird durch die Gradiometerschleifen praktisch voll ausgenutzt, da deren Zuleitungen innerhalb des Bereichs der Schleifen geführt werden.
- Die Zuleitungen im Arraybereich sind als abgedeckte Doppelleitungen ausgebildet, wobei zur Abdeckung die einzelnen Leiterbahnen der Schleifen selbst benutzt werden.
- Durch Ausnutzung der beiden Metallisierungslagen einer Träfolie sowohl für die Schleifen als auch für die Zuleitungen werden im Arraybereich keine Durchkontakte benötigt.
- Die Zuleitungen außerhalb des Arraybereichs sind als Doppelstreifenleiter ausgebildet, die so geschaltet sind, daß die Leitungen unempfindlich gegen homogene Magnetfelder werden.
- Das Gradiometerschleifensystem ist aufgeteilt in zwei Folientypen, nämlich in Folien für die Gradiometerschleifen und in Folien für die Verbindungsleiter. Die Leiterbahnen dieser beiden Folientypen können durch magnetisch abgeschirmte Lötstellen verbunden werden. Durch diese Aufteilung kann die Größe der herzustellenden Folienschaltungen klein gehalten werden.

Gemäß dem in den Figuren dargestellten Ausführungsbeispiel wurde von einem Gradiometer erster Ordnung ausgegangen. Ebensogut lassen sich mit den erfindungsgemäßen Maßnahmen auch Gradiometer nullter oder höherer Ordnung erstellen, deren auf Trägerfolien ausgebildeten Arrays dann auf einer durch den Grad der Ordnung festgelegten Anzahl von Flächen eines Trägerkörpers aufgebracht sind. Der entsprechende Trägerkörper kann dabei auch aus mehreren Teilen zusammengesetzt sein.

## Patentansprüche

1. Einrichtung zur mehrkanaligen Messung schwacher, von mindestens einer Feldquelle hervorgerufener Magnetfelder, welche Einrichtung in jedem Kanal ein supraleitendes Gradiometer mit mindestens einer supraleitenden Gradiometerschleife, ein SQUID sowie supraleitende Verbindungsleiter zwischen der Schleife und dem SQUID enthält, wobei die zu mindestens einem Array (A) zusammengefaßten Gradiometerschleifen (S1, S2) auf einem Trägerkörper (15) angeordnet und ebenso wie die Verbindungsleiter (25, 25') als Dünnfilmstrukturen ausgebildet sind, **dadurch gekennzeichnet,**
- daß die Gradiometerschleifen (S1, S2) auf den beiden Flachseiten (2, 2') einer Trägerfolie (3, 3a) unterschiedlich verteilt angeordnet sind,
- daß die Anordnung der Gradiometerschleifen (S1, S2) derart gewählt ist, daß sie, gemeinsam betrachtet, eine Fläche (F) mit möglichst dicht gepackten, sich nicht überlappenden Gradiometerschleifen (S1, S2) bilden,
- daß die Verbindungsleiter (7a, 7b; 7a', 7b') im Bereich der beiden Flachseiten (2, 2') so verlaufend ausgebildet sind, daß sie zumindest weitgehend von jeweils auf der gegenüberliegenden Flachseite der Trägerfolie (3, 3a) befindlichen Leiterbahnen von Gradiometerschleifen abgeschirmt sind,
und
- daß die Trägerfolie (3, 3a) mit den auf beiden Flachseiten angeordneten Gradiometerschleifen (S1, S2) auf den Trägerkörper (15) aufgebracht ist.

2. Einrichtung nach Anspruch 1, **dadurch gekennzeichnet,** daß die Gradiometerschleifen eines Gradiometers erster oder höherer Ordnung zumindest ein auf beiden Seiten (2, 2') der Trägerfolie (3) angeordnetes Array (A) von Detektionsschleifen (S1, S2) und ein auf beiden Seiten einer weiteren Trägerfolie (3a) angeordnetes Array (A') von Kompensationsschleifen bilden und daß diese Arrays (A, A') auf in parallelen Ebenen liegenden Flächen (16a, 16b) eines Trägerkörpers (15) mit ausgeprägt dreidimensionaler Gestalt angeordnet sind.

3. Einrichtung nach Anspruch 1 oder 2, **dadurch gekennzeichnet,** daß die Supraleitenden Verbindungsleiter (25, 25') außerhalb der die Gradiometerschleifen tragenden Folien (3, 3a) als Zuleitungsfolien (20) gestaltet sind.

4. Einrichtung nach Anspruch 3, **dadurch gekennzeichnet,** daß die Leiterbahnen (25, 25') der supraleitenden Verbindungsleiter auf den beiden Flachseiten (22, 22') der Zuleitungsfolien (20) angeordnet sind.

5. Einrichtung nach Anspruch 3 oder 4, **dadurch gekennzeichnet,** daß zwischen den Trägerfolien (3, 3a) für die Gradiometerschleifen und den Zuleitungsfolien (20) Reihen (8a bis 8d; 8a' bis 8d') von Anschlußpunkten (10a, 10b; 10a', 10b') für die supraleitenden Verbindungsleiter vorgesehen sind.

6. Einrichtung nach einem der Ansprüche 1 bis 5, **dadurch gekennzeichnet,** daß die supraleitenden Verbindungsleiter als Doppelleitungen (7, 7') aus Leiterbahnen gestaltet sind, die entgegengesetzte Stromflußrichtungen aufweisen.

7. Einrichtung nach einem der Ansprüche 3 bis 6, **dadurch gekennzeichnet,** daß die supraleitenden Verbindungsleiter außerhalb der Anordnung der Gradiometerschleifen (S1, S2) zumindest weitgehend von jeweils auf der gegenüberliegenden Flachseite der Trägerfolien (3, 3a; 20) verlaufenden Leiterbahnen (11, 11'; 27, 27') abgeschirmt sind.

8. Einrichtung nach einem der Ansprüche 1 bis 7, **dadurch gekennzeichnet,** daß die die Gradiometerschleifen tragenden Folien (3, 3a) außerhalb des Bereichs ihrer Anordnung jeweils um eine Kante des Trägerkörpers (15) gebogen sind.

9. Einrichtung nach einem der Ansprüche 1 bis 8, **dadurch gekennzeichnet,** daß die Gradiometerschleifen (S1, S2) jeweils die Form eines regelmäßigen 6-Eckes haben.

## Claims

1. Device for the multi-channel measurement of weak magnetic fields generated by at least one field source, which device comprises in each channel a superconducting gradiometer having at least one superconducting gradiometer loop, a SQUID and superconducting connecting lines between the loop and the SQUID, with the gradiometer loops (S1, S2), which are combined to form at least one array (A), being arranged on a carrier body (15) and being formed, as are the connecting lines (25, 25'), as thin film structures, characterised in that:
- the gradiometer loops (S1, S2) are arranged with a different distribution on the two flat sides (2, 2') of a carrier foil (3, 3a),
- the arrangement of gradiometer loops (S1, S2) is selected so that, viewed together, they form a surface (F) having gradiometer loops (S1, S2) packed as densely as possible but not overlapping,
- the connecting lines (7a, 7b; 7a', 7b') are formed in the region of the two flat sides (2, 2') so that they are at least substantially shielded by conductor parts of gradiometer loops located on the respective opposite flat side of the carrier foil (3, 3a), and
- the carrier foil (3, 3a) having the gradiometer loops (S1, S2) arranged on the two flat sides is applied to the carrier body (15).

2. Device according to claim 1, characterised in that the gradiometer loops of a gradiometer of first or higher order form at least one array (A) of detection loops (S1, S2) arranged on the two sides (2, 2') of the carrier foil (3) and one array (A') of compensation loops arranged on the two sides of a further carrier foil (3a) and in that these arrays (A, A') are arranged on surfaces (16a, 16b) in parallel planes of a carrier body (15) having a pronounced three-dimensional shape.

3. Device according to claim 1 or 2, characterised in that the superconducting connecting lines (25, 25') are formed as feeder foils (20) outside the foils (3, 3a) carrying the gradiometer loops.

4. Device according to claim 3, characterised in that the printed conductors (25, 25') of the superconducting connecting lines are arranged on the two flat sides (22, 22') of the feeder foils (20).

5. Device according to claim 3 or 4, characterised in that, between the carrier foils (3, 3a) for the gradiometer loops and the feeder foils (20), rows (8a to 8d; 8a' to 8d') of connecting points (10a, 10b; 10a', 10b') are provided for the connecting lines.

6. Device according to one of claims 1 to 5, characterised in that the superconducting connecting lines are formed as double lines (7, 7') of conductor parts which have opposed directions of current flow.

7. Device according to one of claims 3 to 6, characterised in that the superconducting connecting lines outside the arrangement of gradiometer loops (S1, S2) are at least substantially shielded by conductor parts (11, 11'; 27, 27') running on the respective opposite flat side of the carrier foils (3, 3a; 20).

8. Device according to one of claims 1 to 7, characterised in that the foils (3, 3a) carrying the gradiometer loops are bent about a respective edge of the carrier body (15) outside the region in which they are arranged.

9. Device according of one of claims 1 to 8, characterised in that the gradiometer loops (S1, S2) each have the shape of a regular hexagon.

## Revendications

1. Dispositif pour la mesure à canaux multiples de champs magnétiques faibles, produits par au moins une source de champ, lequel dispositif comporte dans chaque canal un gradiomètre supraconducteur possédant au moins une boucle supraconductrice, un SQUID ainsi que des conducteurs de liaison supraconducteurs entre la boucle et le SQUID, et dans lequel les boucles (S1,S2) des gradiomètres, qui sont réunies pour former au moins un réseau (A), sont disposées sur un corps de support (15) et sont agencées, comme les conducteurs de liaison (25,25'), sous la forme de structures à couches minces, caractérisé par le fait
- que les boucles (S1,S2) des gradiomètres sont disposées en étant réparties différemment sur les deux faces planes (2,2') d'une feuille de support (3,3a),
- que la disposition des boucles (S1,S2) des gradiomètres est choisie de telle sorte que, d'un point de vue global, ces boucles forment une surface (F) possédant des surfaces (S1,S2) des gradiomètres, qui sont tassées d'une manière aussi dense que possible et ne se chevauchent pas,
- que les conducteurs de liaison (7a,7b; 7a',7b') sont agencés au niveau des deux faces planes (2,2'), de manière à s'étendre de telle sorte qu'elles sont protégées au moins dans une large mesure vis-à-vis respectivement de voies conductrices de boucles des gradiomètres, situées sur la face plane opposée de la feuille de support (3,3a), et
- que la feuille de support (3,3a) pourvue des boucles (S1,S2) des gradiomètres, situées sur les deux faces planes, est disposée sur le corps de support (15).

2. Dispositif suivant la revendication 1, caractérisé par le fait que les boucles d'un gradiomètre du premier ordre ou d'un ordre supérieur forment au moins un réseau (A) de boucles de détection (S1,S2), disposé sur les deux faces (2,2') de la feuille de support (3), et un réseau (A') de boucles de compensation, disposé sur les deux faces d'une autre feuille de support (3a), et que ces réseaux (A,A') sont disposés sur des surfaces (16a,16b), qui sont situées dans des plans parallèles d'un corps de support (15) qui possède une configuration tridimensionnelle accusée.

3. Dispositif suivant la revendication 1 ou 2, caractérisé par le fait que les conducteurs de liaison supraconducteurs (25,25') sont réalisés, à l'extérieur des feuilles (3,3a) qui portent les boucles des gradiomètres, sous la forme de feuilles formant conducteurs d'alimentation (20).

4. Dispositif suivant la revendication 3, caractérisé par le fait que les voies conductrices (25,25') des conducteurs de liaison supraconducteur sont disposées sur les deux faces planes (22,22') des feuilles formant conducteurs d'alimentation (20).

5. Dispositif suivant la revendication 3 ou 4, caractérisé par le fait qu'entre les feuilles de support (3,3a), pour les boucles des gradiomètres et les feuilles formant conducteurs d'alimentation (20), sont prévues des séries (8a à 8d; 8a' à 8d') de points de raccordement (10a,10b; 10a',10b') pour les conducteurs de liaison supraconducteurs.

6. Dispositif suivant l'une des revendications 1 à 5, caractérisé par le fait que les conducteurs de liaison supraconducteurs sont réalisés sous la forme de conducteurs doubles (7,7'), constitués par des voies conductrices, dans lesquelles les sens de déplacement du courant sont opposés.

7. Dispositif suivant l'une des revendications 3 à 6, caractérisé par le fait que les conducteurs de liaison supraconducteurs sont protégés, à l'extérieur du dispositif des boucles (S1,S2) des gradiomètres, au moins dans une large mesure, respectivement par des voies conductrices (11,11'; 27,27') qui s'étendent sur les faces planes opposées des feuilles de support (3,3a;20).

8. Dispositif suivant l'une des revendications 1 à 7, caractérisé par le fait que les feuilles de support (3,3a), qui portent les boucles des gradiomètres, sont repliées, à l'extérieur de la zone de leur montage, respectivement autour d'une arête du corps de support (15).

9. Dispositif suivant l'une des revendications 1 à 8, caractérisé par le fait que les boucles (S1,S2) des gradiomètres possèdent respectivement la forme d'un hexagone régulier.
